# EUROPEAN PATENT APPLICATION

(11) **EP 1 918 076 A1**
(43) Date of publication of application: **07.05.2008**
(21) Application number: 07015413.3
(22) Date of filing: 06.08.2007
(51) Int. Cl.: B25J 15/06, B25J 15/00, B25B 11/00

(54) **Vacuum suction system**

(30) Priority: 02.11.2006 KR 20060107692
(71) Applicant: Yang, Yong-Chan, Songjeong-dong, Gumi-si Gyeongsangbuk-do, 730-915 (KR); Seo, Jeong-Imm, 488-16, Songjeong-dong, Gumi-si Gyeongsangbuk-do 730-915 (KR)
(72) Inventor: Yang, Yong-Chan, Songjeong-dong, Gumi-si Gyeongsangbuk-do, 730-915 (KR); Seo, Jeong-Imm, 488-16, Songjeong-dong, Gumi-si Gyeongsangbuk-do 730-915 (KR)
(74) Representative: Scheele, Friedrich

(57) **Abstract**

Provided is a vacuum adsorption system capable of vacuum-adsorbing flat panel type objects such as steel plates, glass, or semiconductor wafers, and various articles having a planar surface, which includes: a suction-compression means (20) for air suction and compression; an adsorption means (30) operating under an active control of a vacuum regulation member (37) according to the existence of a target, the absorption means carrying out the vacuum-adsorption operation if a target exists while stopping the air suction process in the absence of a target; a connection pipe (P) for connecting the suction-compression means and the adsorption means; and a control (or sluice) valve (V) installed in the connection pipe (P) for controlling the air flow. As the vacuum state of the adsorption means can be actively controlled according to the size or shape of a target (ultimately according to the existence of a target), the present invention can provide application advantages, simplifies equipment, and requires a reduced number of components and manufacturing processes, so that price competitiveness of the equipment is improved, electric energy consumption for the application of the system is reduced in use of a minimal number of electrically operated components.

## Description

### BACKGROUND OF THE INVENTION

The present invention relates to a vacuum adsorption system; and, more particularly, to a vacuum adsorption system capable of vacuum-adsorbing flat panel type objects such as steel plates, glass, or semiconductor wafers, and various articles having a planar surface.

Various kinds of adsorption devices have been developed and are currently used for vacuum-adsorbing a hexahedral object in a flat panel shape or having a planar surface and transporting the picked object to a desired location. Most adsorption devices are provided with a number of adsorption means (pad, adsorbing pores, etc.) installed in blocks which are specially manufactured according to size of an object to be adsorbed.

Such a conventional adsorption means adsorbs and compresses air with the aid of an air solenoid and the like, to vacuum-adsorbing an object (or target) by compressed air. Each adsorption means has an air solenoid to be able to control its vacuum state.

Since the adsorption device having the adsorption means of the configuration described above utilizes multiple air solenoids for control of the vacuum state, not only the purchase price of parts is steep, but also manufacturing processes increases, leading to an increase in manufacture cost.

Moreover, the conventional adsorption device is a customer made device, which is made to order according to the size of an adsorption target. This means that the adsorption device must be modified or manufactured again every time the size or the shape of the adsorption target is changed. To avoid such a tedious re-manufacturing process, a special program is required to adjust the quantity or the shape of the adsorption means in operation. However, this type of equipment turned out to be not the best choice because it is in need of additional components, resulting in an increase of price of the equipment. Also, because a user should set the operation type of the adsorption means according to every change in an adsorption target, the equipment is considered rather troublesome from its application standpoint.

Various problems of the conventional adsorption device are ascribed to an adsorption system of the adsorption means which uses things like an air solenoid for example in order to control adsorption (vacuum) and an interruption of the adsorption. Therefore, there is a great need to develop a vacuum adsorption system capable of actively controlling adsorption and an interruption of the adsorption in itself.

### SUMMARY OF THE INVENTION

In view of the foregoing problems of the conventional vacuum adsorption device, it is, therefore, an object of the present invention to provide an advanced vacuum adsorption system, which is capable of actively controlling an operation state (vacuum/adsorption) of a valve according to the existence of a target, without the use of air solenoids or special operations, to thereby adsorb the target in various sizes or shapes, and which is built to improve work convenience, to reduce manufacturing costs of the equipment, and to accommodate a minimal number of electrically operated components for cutting operation cost of the equipment.

In accordance with the present invention, there is provided a vacuum adsorption system, including: a suction-compression means for air suction and compression; an adsorption means operating under an active control of a vacuum regulation member according to the existence of a target, such as, carrying out the vacuum-adsorption operation if a target exists while stopping the air suction process in the absence of a target; a connection pipe for connecting the suction-compression means and the adsorption means; and a control (or sluice) valve installed in the connection pipe P for controlling the air flow.

The other objectives and advantages of the invention will be understood by the following description and will also be appreciated by the embodiments of the invention more clearly. Further, the objectives and advantages of the invention will readily be seen that they can be realized by the means and its combination specified in the claims.

### BRIEF DESCRIPTION OF THE DRAWINGS

Fig. 1 is a schematic view of a vacuum adsorption system in accordance with the present invention;

Fig. 2 is a referential diagram depicting a preferred embodiment of a vacuum adsorption system in accordance with the present invention;

Fig. 3 is a referential cross-sectional view of a preferred embodiment of an adsorption means in accordance with the present invention;

Fig. 4 is an enlarged perspective view of a vacuum regulation member excerpted from Fig. 3;

Figs. 5[A] and [B] are referential cross-sectional views for explaining the operation state of a vacuum regulation member;

Fig. 6 is a referential view of another embodiment of the adsorption means in accordance with the present invention, in which [A] is a lateral cross-sectional view and [B] is a front cross-sectional view;

Fig. 7 is a referential cross-sectional view of still another embodiment of the adsorption means in accordance with the present invention;

Fig. 8 is a referential cross-sectional view of still another embodiment of the adsorption means in accordance with the present invention;

Fig. 9 is a referential cross-sectional view of yet another embodiment of the adsorption means in accordance with the present invention; and

Fig. 10 is a referential perspective view of an adsorption means in accordance with the present invention being put into practice.

### DESCRIPTION OF SPECIFIC EMBODIMENTS

Hereinafter, preferred embodiments of the present invention will be set forth in detail with reference to the accompanying drawings so that those skilled in the art can easily carry out the invention.

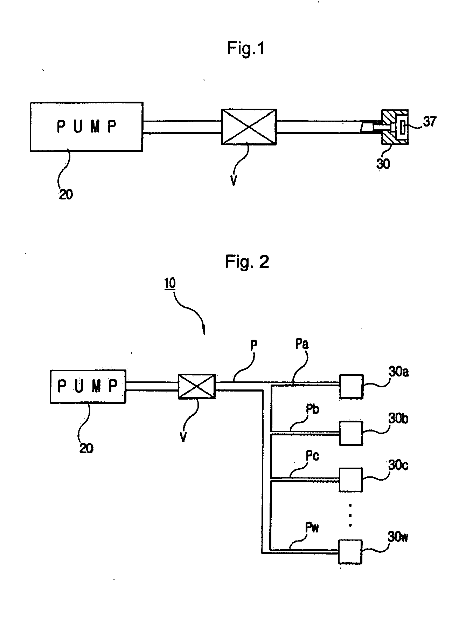

Fig. 1 illustrates a schematic view of a vacuum adsorption system 10 suggested by the present invention, which includes a suction-compression means 20 for air suction and compression; an adsorption means 30 operating under an active control of a vacuum regulation member 37 according to the existence of a target, such as, carrying out the vacuum-adsorption operation if a target exists while stopping the air suction process in the absence of a target; a connection pipe P for connecting the suction-compression means 20 and the adsorption means 30; and a control (or sluice) valve V installed in the connection pipe P for controlling the air flow.

Fig. 2 is a referential diagram depicting a preferred embodiment of a vacuum adsorption system 10 suggested by the present invention. As shown in the drawing, the vacuum adsorption system 10 includes a plurality of adsorption means 30a, 30b, 30c, ..., and 30w, and a plurality of branch pipes Pa, Pb, Pc, ..., and Pw that are branched from a connection pipe P, in which the branch pipes are closely connected to the adsorption means, respectively, to allow each of the adsorption means 30a, 30b, 30c, ..., and 30w to operate the vacuum-adsorption process independently.

The present invention vacuum adsorption system with the above configuration works under an active control of the vacuum regulation member 37 according to the existence of a target. For instance, when an adsorption target comes in contact with the adsorption means 30, the suction-compression means 20 sucks the target up, causing the target to adsorb to the adsorption means 30. Meanwhile, when an adsorption target is not in contact with the adsorption means 30, the vacuum regulation member 37 controls an adsorption operation of the adsorption means 30 by the suction operation of the suction-compression means 20. More specific embodiments of the present invention are now explained below.

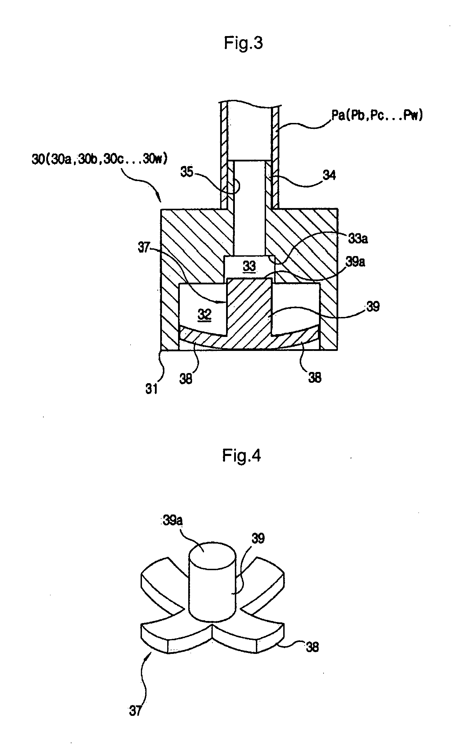

Fig. 3 shows a preferred embodiment of the adsorption means 30 (30a, 30b, 30c, ..., and 30w), in accordance with the present invention. As shown in the drawing, the adsorption means 30 (30a, 30b, 30c, ..., and 30w) includes a connection pipe P or a joint pipe 34 capable of joining branch pipes Pa, Pb, Pc, ..., and Pw, and a housing 31. Inside the housing 31 is an opening/closing chamber 33 with a greater diameter than an intake port 35 provided to the joint pipe 34, so that a stepped surface 33a is formed between the intake port 35 and the opening/closing chamber 33. In addition, a vacuum chamber 32 is formed underneath the opening/closing chamber 33 to be able to communicate with the opening/closing chamber 33. The vacuum regulation member 37 described above is housed in this vacuum chamber 32.

Fig. 4 shows a preferred embodiment of the vacuum regulation member 37, in accordance with the present invention. The vacuum regulation member 37 is preferably made of a flexible synthetic resin excellent in elasticity and resilience. As depicted in the drawing, the vacuum regulation member 37 is formed by connecting a support plate 38 in form of angularly spaced radial wings to an opening/closing section 39 as one body.

An outer diameter (external diameter) of the support plate 38 is slightly larger than an inner diameter (internal diameter) of the vacuum chamber 32, so that the vacuum regulation member 37 may be compressively attached onto the inner wall surface of the vacuum chamber 32. An opening/closing surface 39a, making a close surface contact with the stepped surface 33a formed between the intake port 35 and the opening/closing chamber 33, is formed on an upper portion of the opening/closing section 39 provided to the vacuum regulation member 37. The opening/closing section 39 has an outer diameter to be able to fit in the opening/closing chamber 33 and to accommodate the intake port 35. In this way, the intake port 35 may be closed by the opening/closing surface 39a of the opening/closing section 39.

Moreover, the top surface of each support plate 38 of the vacuum regulation member 37, that is, the surface opposed to the opening/closing chamber 33, is curved downwardly to be faced with the opening/closing chamber 33. This structure promotes an interaction between the elastic support plate 38 and the curved surfaces, thereby doubling the elasticity of the support plate 38. Consequently, the resilience of the vacuum regulation member 37 may retain an excellent level of resilience.

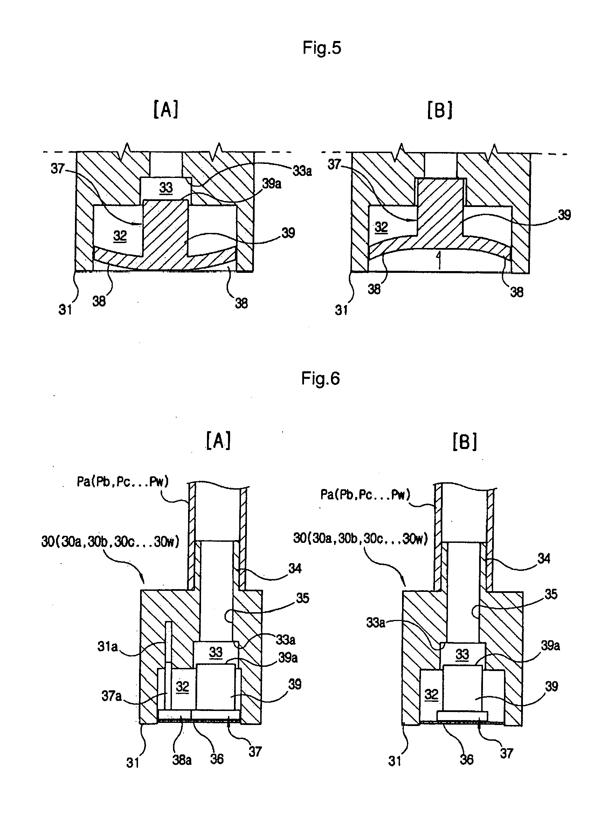

When the suction-compression means 20 operates a suction process while the bottom of the vacuum chamber 32 being open, the opening/closing section 39 formed at the support plate 38 of the vacuum regulation member 37 is pulled or drawn to the opening/closing chamber 33 by the suction force, and the opening/closing surface 39a of the opening/closing section 39 covers the intake opening 35. In this procedure, since the support plate 38 of the vacuum regulation member 37 is compressively attached onto the inner wall surface of the vacuum chamber 32, only the opening/closing surface 39 is elongated by a certain length to shut the intake port 35. On the other hand, when the suction process by the suction-compression means 20 stops, the opening/closing section 39 returns to its original position by the elastic and resilient nature of the vacuum regulation member 37 (refer to Figs. 5[A] and [B]).

The opening/closing chamber 33 and the vacuum regulation member 37 constituting the adsorption means 30a, 30b, 30c, ..., and 30w may be manufactured in diverse forms capable of controlling a vacuum state of the vacuum chamber 32 through the suction process of the suction-compression means 20. Therefore, the following will now explain other embodiments of the opening/closing chamber 33 and the vacuum regulation member 37.

Embodiment 1

Fig. 6 shows another embodiment of the adsorption means 30a, 30b, 30c, ..., and 30w, in accordance with the present invention. As depicted in the drawing, the adsorption means 30a, 30b, 30c, ..., and 30w includes a connection pipe P or a joint pipe 34 for joining branch pipes Pa, Pb, Pc, ..., and Pw, and a housing 31. Inside the housing 31 is an opening/closing chamber 33 with a greater diameter than an intake port 35 provided to the joint pipe 34, so that a stepped surface 33a is formed between the intake port 35 and the opening/closing chamber 33. In addition, a vacuum chamber 32 is formed underneath the opening/closing chamber 33 to be able to communicate with the opening/closing chamber 33. The vacuum chamber 32 accommodates a vacuum regulation member 37 inside.

A pin hole 31a is formed in the vacuum chamber 32, and an opening/closing section 39 with an opening/closing surface 39a making a close surface contact with the stepped surface 33a is formed on a support plate of the vacuum regulation member 37. Moreover, an aileron 38a is protrusively formed in one side of the support plate 38, and a control pin 37a that is fittingly inserted into the pin hole 31a is formed on the aileron 38a.

At this time, the support plate 38 takes a rectangular oval shape, of which major axis end has a diameter approximate to the inner diameter of the vacuum chamber 32, so that air may flow through a space (gap) formed between the short axis end of the support plate 38 and the inner wall of the vacuum chamber 32. Meanwhile, the opening/closing section 39 has an outer diameter that is small enough to fit into the opening/closing chamber 33 yet is large enough to accommodate the intake port 35, to thereby enable the opening/closing surface 39a of the opening/closing section 39 to close the intake port 35.

Embodiment 2

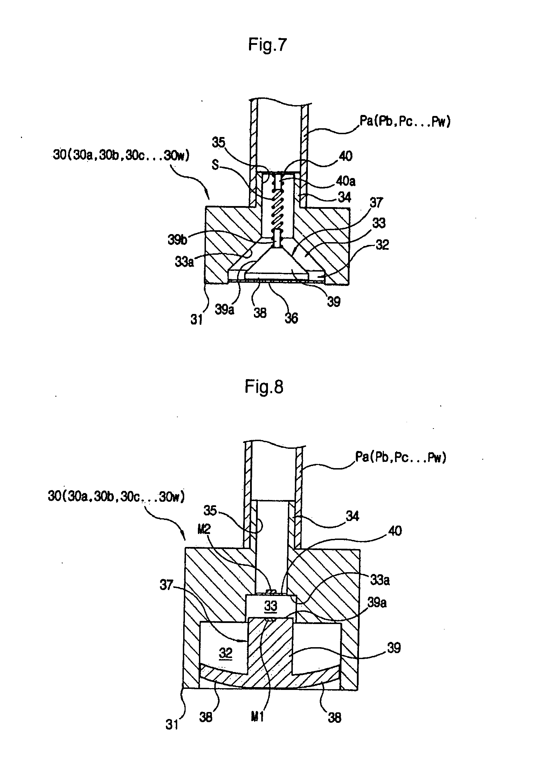

Fig. 7 shows still another embodiment of the adsorption means 30a, 30b, 30c, ..., and 30w, in accordance with the present invention. As depicted in the drawing, the adsorption means 30a, 30b, 30c, ..., and 30w includes a connection pipe P or a joint pipe 34 for joining branch pipes Pa, Pb, Pc, ..., and Pw, and a housing 31. Inside the housing 31 is an opening/closing chamber 33 with a greater diameter than an intake port 35 provided to the joint pipe 34, so that a stepped surface 33a is formed between the intake port 35 and the opening/closing chamber 33. In addition, a vacuum chamber 32 is formed underneath the opening/closing chamber 33 to be able to communicate with the opening/closing chamber 33. The vacuum chamber 32 accommodates a vacuum regulation member 37 inside.

The stepped surface 33a of the opening/closing chamber 33 has a conical shape with a narrow top and widening lower portion, and an auxiliary plate 40, which has a plurality of vents and a support pin 40a at the center, is installed at the top of the suction hole 35. In the vacuum regulation member 37, an opening/closing surface 39a is formed on a support plate 38 in a conical shape with a narrow top and widening lower portion, similarly to the stepped surface 33a of the opening/closing chamber 33, and a support pin 39b is formed on an upper surface of the vacuum regulation member 37. Then, a shooting spring S is interposed between the support pin 40a formed on the auxiliary plate 40 and the support pin 39a formed on the vacuum regulation member 37, to separate the vacuum regulation member 37 from the stepped surface 33a of the opening/closing chamber 33 by the elasticity of the shooting spring S.

At this time, the support plate 38 has a smaller diameter than the inner diameter of the vacuum chamber 32, so that air may flow through a space (gap) formed between the support plate 38 and the inner wall of the vacuum chamber 32.

**Embodiment 3**

Fig. 8 shows still another embodiment of the adsorption means 30a, 30b, 30c, ..., and 30w, in accordance with the present invention. As depicted in the drawing, the adsorption means 30a, 30b, 30c, ..., and 30w includes a connection pipe P or a joint pipe 34 for joining branch pipes Pa, Pb, Pc, ..., and Pw, and a housing 31. Inside the housing 31 is an opening/closing chamber 33 with a greater diameter than an intake port 35 provided to the joint pipe 34, so that a stepped surface 33a is formed between the intake port 35 and the opening/closing chamber 33. In addition, a vacuum chamber 32 is formed underneath the opening/closing chamber 33 to be able to communicate with the opening/closing chamber 33. The vacuum chamber 32 accommodates a vacuum regulation member 37 inside. Desirably, the vacuum regulation member 37 is made of a flexible synthetic resin excellent in elasticity and resilience, and is formed by connecting a support plate 38 in form of angularly spaced radial wings to an opening/closing section 39 as one body. An opening/closing surface 39a, making a close surface contact with the stepped surface 33a formed between the intake port 35 and the opening/closing chamber 33, is formed on an upper portion of the opening/closing section 39.

Moreover, an auxiliary plate 40 with a plurality of vents formed on the top is installed at an upper portion of the opening/closing chamber 33. Then, a magnet M2 is installed at an upper surface of the auxiliary plate 40, and a magnet M1 corresponding to the magnet M2 is laid in the upper surface of the opening/closing section 39 of the vacuum regulation member 37. Here, the magnet M1 laid in the opening/closing section 39 of the vacuum regulation member 37 and the magnet M2 installed at the auxiliary plate 40 are positioned to have the same polarity, so that the vacuum regulation member 37 may be retained being separated from the stepped surface 33a of the opening/closing chamber 33 by a repulsive force of the magnets M1 and M2.

**Embodiment 4**

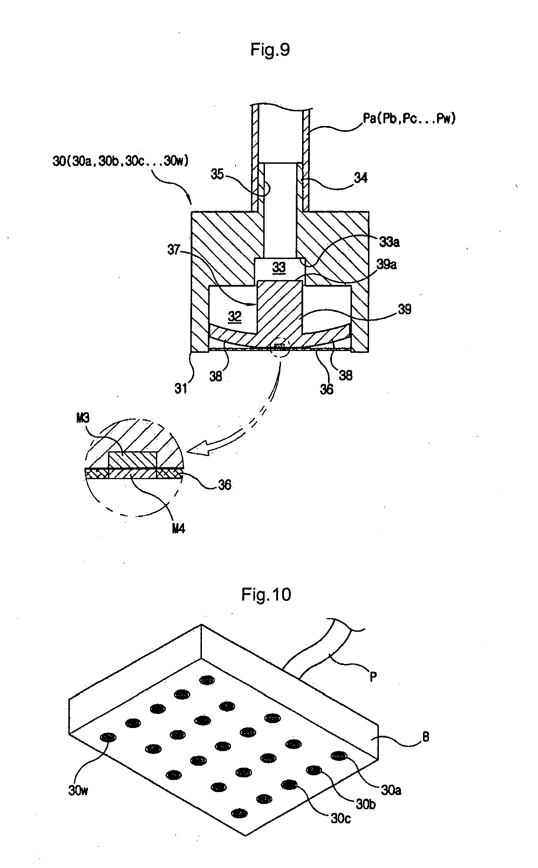

Fig. 9 shows yet another embodiment of the adsorption means 30a, 30b, 30c, ..., and 30w, in accordance with the present invention. As depicted in the drawing, the adsorption means 30a, 30b, 30c, ..., and 30w includes a connection pipe P or a joint pipe 34 for joining branch pipes Pa, Pb, Pc, ..., and Pw, and a housing 31. Inside the housing 31 is an opening/closing chamber 33 with a greater diameter than an intake port 35 provided to the joint pipe 34, so that a stepped surface 33a is formed between the intake port 35 and the opening/closing chamber 33. In addition, a vacuum chamber 32 is formed underneath the opening/closing chamber 33 to be able to communicate with the opening/closing chamber 33. The vacuum chamber 32 has a cover plate 36 to cover its bottom, while having a vacuum regulation member 37 inside. Desirably, the vacuum regulation member 37 is made of a flexible synthetic resin excellent in elasticity and resilience, and is formed by connecting a support plate 38 in form of angularly spaced radial wings to an opening/closing section 39 as one body. An opening/closing surface 39a, making a close surface contact with the stepped surface 33a formed between the intake port 35 and the opening/closing chamber 33, is formed on an upper portion of the opening/closing section 39.

Then, a magnet M3 is laid in the bottom of the support plate 38 of the vacuum regulation member 37, and a magnet M4 corresponding to the magnet M3 is laid in the cover plate 36 of the vacuum chamber 32. Here, the magnet M3 laid in the bottom of the support plate 38 of the vacuum regulation member 37, and the magnet M4 laid in the cover plate 36 of the vacuum chamber 32 are positioned to have the opposite polarity, so that the vacuum regulation member 37 may be retained being separated from the stepped surface 33a of the opening/closing chamber 33 by a magnetic force between magnets M3 and M4.

In the present invention with the above constitution, the adsorption means 30 performs an active vacuum-adsorption operation according to the existence of a target through the suction operation of the suction-compression means 20. In case of realizing an adsorption equipment with a plurality of adsorption means 30, each of the adsorption means 30a, 30b, 30c, ..., and 30w is preferably laid in or fixed at a support block B (refer to Fig. 10). The following will now explain an operation of the adsorption equipment constituted with multi-adsorption means.

With the suction-compression means 20 being in operation, the absorption means 30a, 30b, 30c, ..., or 30w specifically selected according to the size or shape of an absorption target is adhered to the target, and a control valve V is open. Then, the selected adsorption means 30a, 30b, 30c, ..., or 30w makes the vacuum chamber 32 into a vacuum state to adsorb the target. Meanwhile, in case of other adsorption means 30a, 30b, 30c, ..., or 30w that are free from the target, the vacuum regulation member 37 closes the intake port 35, so that the vacuum state of the adsorption means 30a, 30b, 30c, ..., and 30w having been selected for adsorbing the target is maintained effectively.

That is, while an adsorption target is adhered to the adsorption means 30a, 30b, 30c, ..., or 30w (to be more specific, to the bottom of a housing 31 of the adsorption means), even though air is sucked up by the suction-adsorption means 20, the vacuum chamber 32 retains its vacuum state, and no vacuum-adsorption process is carried out on the target. Since the inside of the vacuum chamber 32 is in the vacuum state with no air flow, the vacuum regulation member 37 maintains its original position (being separated from the stepped surface 33a of the opening/closing chamber 33), thereby exerting no influence on the vacuum state inside the vacuum chamber 32.

Moreover, in case that the bottom of the housing 31 of the adsorption means 30a, 30b, 30c, ..., or 30w is free from the target or is not completely adhered to the target, the vacuum regulation member 37 in a corresponding adsorption means 30a, 30b, 30c, ..., or 30w closes the intake port 35. This consequently helps the adsorption means 30a, 30b, 30c, ..., or 30w of interest retain its vacuum (adsorption) state well. To detail its procedure, when the suction-compression means 20 starts running, air is sucked up from outside through the intake port 35, and the vacuum regulation member 37 is sucked towards the opening/closing chamber 33 by the air flow. In consequence, the opening/closing surface provided at the opening/closing section 39 of the vacuum regulation member 37 makes a surface contact with the stepped surface 33a formed between the intake port 35 and the opening/closing chamber 33, and shuts the intake port 35, to thus interrupt the air flow.

In short, an adsorption means 30a, 30b, 30c, ..., or 30w adsorbing the target maintains its vacuum-adsorption state thanks to the target, while an adsorption means 30a, 30b, 30c, ..., or 30w not adsorbing the garget maintains its vacuum state by the operation of the vacuum regulation member 37. In this manner, each of the adsorption means 30a, 30b, 30c, ..., and 30w adsorbing the target maintains a good vacuum (adsorption) state, and the vacuum adsorption system can perform the vacuum and adsorption processes more flexibly on targets in various sizes or shapes.

As has been explained, the vacuum adsorption system suggested by the present invention is capable of performing an adsorption process without the use of an air solenoid and the like, and requires a minimal number of consumable components not only to facilitate the manufacture of the equipment but also to minimize the manufacturing costs.

In fact, in case of applying the present invention to the adsorption equipment, the vacuum state of the adsorption means can be actively controlled according to the size or shape of a target, without any special manipulation skills required. That is, the present invention may provide application advantages in that a single system is sufficient for the efficient adsorption of targets in diverse sizes, without a special operation (drive) program and so on.

Moreover, since electrically driven air solenoids or drive programs are not used, electric energy consumption for the application of the system can be minimized. This in turn creates economic benefits and other merits, making the present invention even more useful.

While the present invention has been described with respect to the specific embodiments, it will be apparent to those skilled in the art that various changes and modifications may be made without departing from the spirit and scope of the invention as defined in the following claims.

## Claims

1. A vacuum adsorption system, comprising:
a suction-compression means for air suction and compression;
an adsorption means operating under an active control of a vacuum regulation member according to the existence of a target, the absorption means carrying out the vacuum-adsorption operation if a target exists while stopping the air suction process in the absence of a target;
a connection pipe for connecting the suction-compression means and the adsorption means; and
a control (or sluice) valve installed in the connection pipe P for controlling the air flow.

2. The vacuum adsorption system of claim 1 comprises a plurality of adsorption means, and a plurality of branch pipes being branched from the connection pipe P, wherein the branch pipes are closely connected to the adsorption means, respectively, to allow each of the adsorption means to operate the vacuum-adsorption process independently.

3. The vacuum adsorption system of claim 1 or claim 2, wherein the adsorption means comprises:
a connection pipe or a joint pipe capable of joining branch pipes; and
a housing provided with an opening/closing chamber with a greater diameter than an intake port formed in the joint pipe, so as to form a stepped surface between the intake port and the opening/closing chamber, wherein a vacuum chamber is formed underneath the opening/closing chamber in a communicable manner with the opening/closing chamber, and a vacuum regulation member is installed in the vacuum chamber.

4. The vacuum adsorption system of claim 1 or claim 3, wherein the vacuum regulation member is made of a flexible synthetic resin excellent in elasticity and resilience, and is constituted by a support plate in form of angularly spaced radial wings that are connected to an opening/closing section as one body; and
wherein an outer diameter of the support plate is slightly larger than an inner diameter of the vacuum chamber, enabling the vacuum regulation member to be compressively attached onto the inner wall surface of the vacuum chamber, an opening/closing surface, making a close surface contact with the stepped surface formed between the intake port and the opening/closing chamber, is formed on an upper portion of the opening/closing section provided to the vacuum regulation member, and the opening/closing section has an outer diameter small enough to fit into the opening/closing chamber yet large enough to accommodate the intake port, to make the intake port shut by the opening/closing surface of the opening/closing section.

5. The vacuum adsorption system of claim 1 or claim 3,
wherein a pin hole is formed in the vacuum chamber, the opening/closing section with an opening/closing surface making a close surface contact with the stepped surface is formed on a support plate of the vacuum regulation member, an aileron is protrusively formed in one side of the support plate, and a control pin that is fittingly inserted into the pin hole is formed on the aileron; and
wherein the support plate takes a rectangular oval shape, of which major axis end has a diameter approximate to the inner diameter of the vacuum chamber, so that air flows through a space (gap) formed between the short axis end of the support plate and the inner wall of the vacuum chamber, and the opening/closing section has an outer diameter small enough to fit into the opening/closing chamber yet large enough to accommodate the intake port, to make the intake port shut by the opening/closing surface of the opening/closing section.

6. The vacuum adsorption system of claim 1 or claim 3,
wherein the stepped surface of the opening/closing chamber has a conical shape with a narrow top and widening lower portion, an auxiliary plate having a plurality of vents and a support pin formed at the center is installed at the top of the suction hole, the vacuum regulation member has an opening/closing surface formed on a support plate that has a conical shape with a narrow top and widening lower portion, similarly to the stepped surface of the opening/closing chamber, a support pin is formed on an upper surface of the vacuum regulation member, and a shooting spring is interposed between the support pin formed on the auxiliary plate and the support pin formed on the vacuum regulation member, to separate the vacuum regulation member from the stepped surface of the opening/closing chamber by the elasticity of the shooting spring; and
wherein, the support plate has a smaller diameter than the inner diameter of the vacuum chamber, so that air flows through a space (gap) formed between the support plate and the inner wall of the vacuum chamber.

7. The vacuum adsorption system of claim 1 or claim 3,
wherein an auxiliary plate with a plurality of vents formed on the top is installed at an upper portion of the opening/closing chamber, a magnet M2 is installed at an upper surface of the auxiliary plate, and a magnet M1 corresponding to the magnet M2 is laid in the upper surface of the opening/closing section of the vacuum regulation member, the magnet M1 laid in the opening/closing section of the vacuum regulation member and the magnet M2 installed at the auxiliary plate being positioned to have the same polarity, so that the vacuum regulation member retains a position separated from the stepped surface of the opening/closing chamber by a repulsive force of the magnets M1 and M2.

8. The vacuum adsorption system of claim 1 or claim 3,
wherein a magnet M3 is laid in the bottom of the support plate of the vacuum regulation member, and a magnet M4 corresponding to the magnet M3 is laid in the cover plate of the vacuum chamber, the magnet M3 laid in the bottom of the support plate of the vacuum regulation member and the magnet M4 laid in the cover plate of the vacuum chamber being positioned to have the opposite polarity, so that the vacuum regulation member retains a position separated from the stepped surface of the opening/closing chamber by a magnetic force between magnets M3 and M4.
